# EUROPEAN PATENT SPECIFICATION

(11) **EP 2 975 315 B1**
(45) Date of publication and mention of the grant of the patent: **19.06.2019**
(21) Application number: 14764826.5
(22) Date of filing: 14.03.2014
(51) Int. Cl.: F16M 13/02, H05K 5/02, F16B 2/12

(54) **INSTALLATION DEVICE**
INSTALLATIONSVORRICHTUNG
DISPOSITIF D'INSTALLATION

(30) Priority: 14.03.2013 CN 201320116998 U
(43) Date of publication of application: 20.01.2016
(73) Proprietor: ZTE Corporation, Shenzhen, Guangdong 518057 (CN)
(72) Inventor: ZHAI, Shixuan, Shenzhen Guangdong 518057 (CN); QIN, Haiyan, Shenzhen Guangdong 518057 (CN)
(74) Representative: Lavoix
(86) International application number: PCT/CN2014/073482
(87) International publication number: WO 2014/139471

(56) References cited:
- EP-A1- 0 850 594
- EP-A1- 2 309 832
- WO-A1-2010/045979
- WO-A1-2012/094890
- CN-U- 202 708 522
- CN-U- 203 375 124
- CN-Y- 201 097 472
- CN-Y- 201 159 381
- JP-A- 2005 299 763
- US-A- 5 431 509

## Description

### TECHNICAL FIELD

The disclosure relates to the field of communications, and in particular to an installation device.

### BACKGROUND

EP 2 309 832 A1 discloses an assembly of a mounting component and communications equipment is provided. The mounting component for mounting the communications equipment includes a main fastener and an auxiliary fastener The main fastener is coupled with the auxiliary fastener and is fixed on a fixture. The main fastener has a connecting portion for interlocking a retaining member of the communications equipment. The main fastener includes a front side, a rear side, a left side, and a right side. The front side is formed with a clamp portion of the main fastener, and the rear side is disposed with the connecting portion for interlocking the retaining member of the communications equipment.

US 5,431,509 relates to a system for interlocking a plurality of modules, such as medical instrument modules (e.g., infusion pumps), in side-by-side relationship such that not more than one module can be mounted on each side of a center module.

CN202708522 concerns a through-connection mounting support frame, a through-connection mounting part and an electronic device, and relates to the electronic devices. The through-connection mounting support frame and the through-connection mounting part can be mutually connected in butt joint mode to form mounting surfaces with arbitrary sizes, universality is high, the through-connection mounting support frame and the through-connection mounting part are suitable for mounting sites of a singular module or multiple modules, is especially suitable for integrated mounting sites of shared poles or shared hanging walls, and mounting sites where a singular module is upgraded to form multiple modules.

At present, outdoor equipment of electronic products is widely used. An installation mode mainly adopts a pole, a wall-hung shelf and other modes. An electronic product is fixed on an installation rod through an installation device.

Since an installation condition cannot be determined, there might be a round rod, an angle iron, a steel channel or a wall-hung shelf, or, the diameter of the rod, the sizes of the angle iron and the steel channel probably are different, a higher demand is put forward on the applicability of the installation device and the installation possibility of the project.

In order to solve the above problem, it is necessary to design a fixed reliable installation device which has a wide suitability and a high installation functionality and which can reduce the work load of operators, simplify operation procedures and shorten the installation time. The optimization of installation also greatly saves the project cost of the complete machine.

In view of the above problem in related art, no solution has been proposed so far.

### SUMMARY

In view of the technical problem in related art that the existing installation mode has a narrow range of application and the operation is complex during installation, the disclosure provides an installation device to solve at least the above problem
According to one aspect of the disclosure, an installation device according to claim 1 is provided.

Preferably, the fixing clamp is provided with a first installation hole, the connection piece passes through two first installation holes on two fixing clamps arranged opposite each other to install the two fixing clamps on the installation rod.

Preferably, the connection piece includes a first connection component and a second connection component; the second connection component is provided with a second installation hole, the first connection component passes through the second installation hole to install the fixing clamp on the installation rod.

Preferably, the fixing clamp is provided with a hanging groove; the installation plate is provided with a lug; the hanging groove is matched with the lug to install the installation plate on the fixing clamp.

Preferably, the first hanging structure and the second hanging structure are respectively provided with a first locking structure and a second locking structure that are matched with each other, and lock the fixing clamp and the adapter plate through the first locking structure and the second locking structure that are mutually matched.

Preferably, the first locking structure is a locking groove and the second locking structure is a thread hole; the locking groove and the thread hole lock the fixing clamp and the adapter plate via a screw.

Preferably, there are multiple adapter plates and a plurality of other fixing clamps.

In the disclosure, pole installation is realized through a fixing clamp and a connection piece, an apparatus to be installed is installed through an installation plate and an adapter plate is used to extend the installation of fixing clamps to install more apparatuses, thus, the disclosure solves the technical problems in the related art that the existing installation mode has a narrow range of application and the operation is complex during installation, etc., thereby achieving the effects of a wide range of application and simple installation.

### BRIEF DESCRIPTION OF THE DRAWINGS

Fig. 1 shows a structure diagram of an installation device according to the disclosure;
Fig. 2 shows a structure diagram of a fixing clamp according to the disclosure;
Fig. 3 shows a structure diagram of an installation plate according to the disclosure;
Fig. 4 shows a structure diagram of an adapter plate according to the disclosure;
Fig. 5 shows a diagram of connection between an installation plate and an apparatus to be installed according to the disclosure;
Fig. 6 shows a structure diagram of pole installation according to the disclosure;
Fig. 7 shows a structure diagram of extended installation according to the disclosure;
Fig. 8 shows a state diagram of extended installation according to the disclosure;
Fig. 9 shows an example of a fixing clamp;
Fig. 10 shows a structure diagram of a second connection component according an example; and
Fig. 11 shows a state diagram after the installation shown in Fig. 9.

### DETAILED DESCRIPTION

The disclosure is described below in detail by reference to the accompanying drawings in conjunction with embodiments. It should be noted that the embodiments in the application and the characteristics of the embodiments can be combined if no conflict is caused.

### Embodiment 1

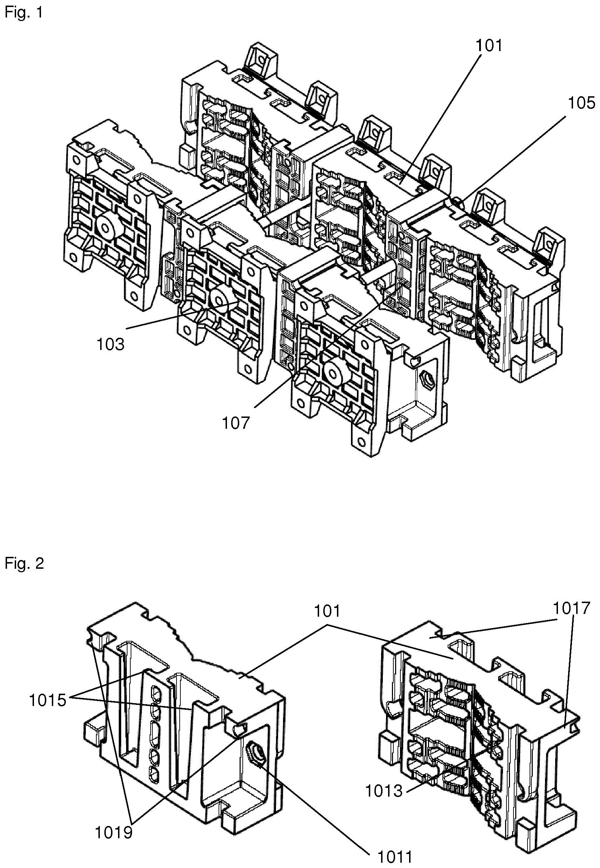

Fig. 1 shows a structure diagram of an installation device according to the disclosure; as shown in Fig. 1, the installation device includes a fixing clamp 101, an installation plate 103, an adapter plate 105 and a connection piece 107, wherein
the fixing clamp 101 is arranged on an installation rod (or called a pole) via the connection piece 107 that is used in concert with the fixing clamp 101; that is, the fixing clamp 101 is matched with the connection piece 107 to install the fixing clamp 101 on the installation rod (or called a pole);
an apparatus to be installed is arranged on the installation plate 103 via the fixing clamp 101 connected with the installation plate 103; that is, the installation plate 103 is connected with the fixing clamp 101 to install the apparatus to be installed; and
other fixing clamps except the above mentioned fixing clamp are arranged on the adapter plate 105 via the fixing clamp 101 connected with the adapter plate 105; that is, the adapter plate 105 is connected with the fixing clamp 101 to install other fixing clamps except the above mentioned fixing clamp 101.

The installation device formed by the above structure can be applied to multiple installation scenes; since the installation is simple, the installation device can greatly reduce the procedure, complexity and working time of high-altitude operation and reduce the space occupied by installation, thereby reducing the cost of construction and enhancing the security.

In this embodiment, when the number of the fixing clamps 101 is an even number (at least two), all fixing clamps are installed in pairs on opposite sides of the installation rod; when the number of the fixing clamps 101 is an odd number, the fixing clamp 101 can be installed according to actual conditions.

In this embodiment, there are multiple installation modes for the fixing clamp and the installation rod, for example:

### First implementation mode:

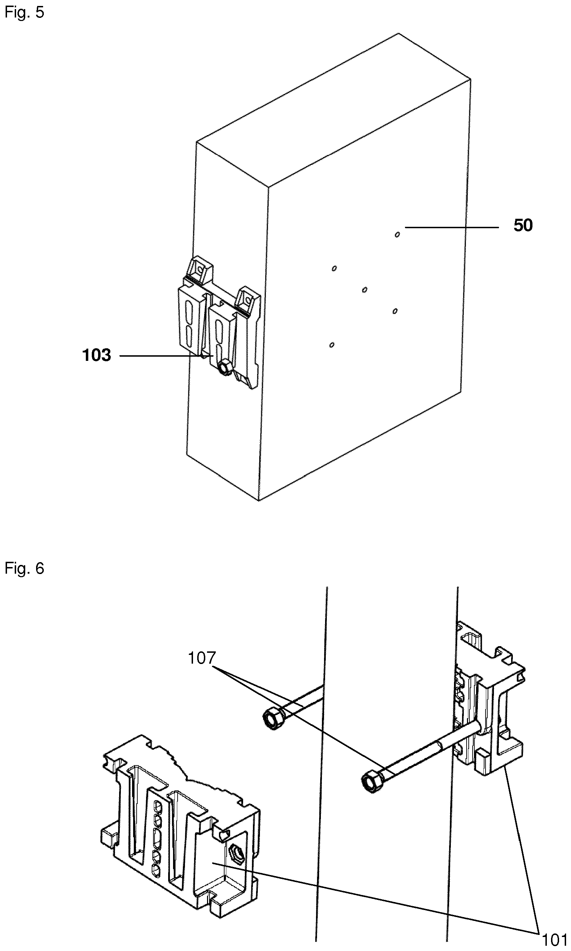

As shown in Fig. 2, the fixing clamp 101 is provided with a first installation hole 1011, the first installation hole 1011 is matched with the connection piece 107 (as shown in Fig. 6) (that is, the connection piece 107 passes through two first installation holes 1011 on two fixing clamps arranged opposite each other) to install the fixing clamp 101 on the installation rod; the installation hole here might be but not limited to a thread hole; correspondingly, the connection piece 107 might be a bolt. In addition, it is needed to note that both ends of each fixing clamp 101 may be provided respectively with a first installation hole 1011 when the fixing clamps 101 are installed opposite each other.

### Second implementation mode:

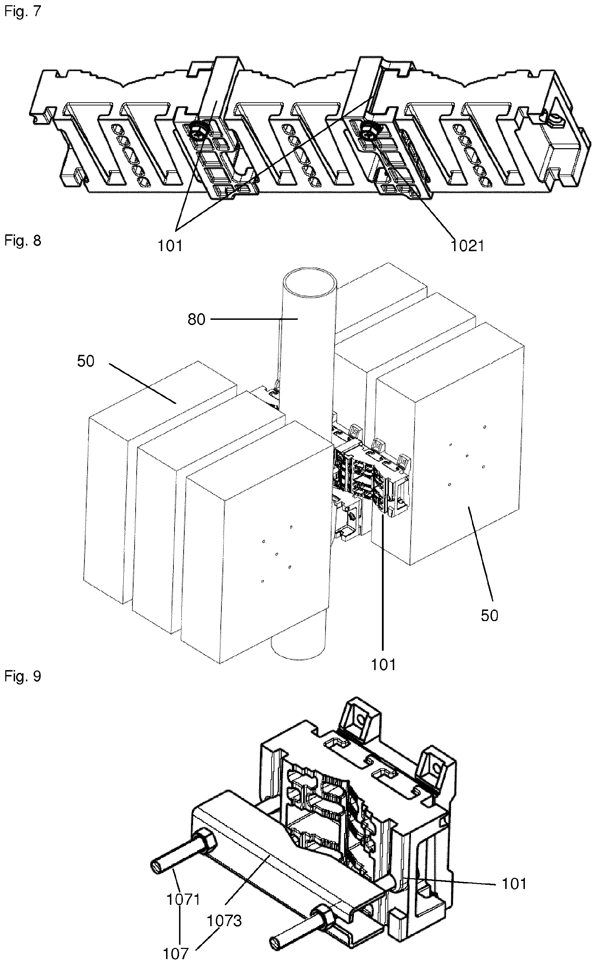

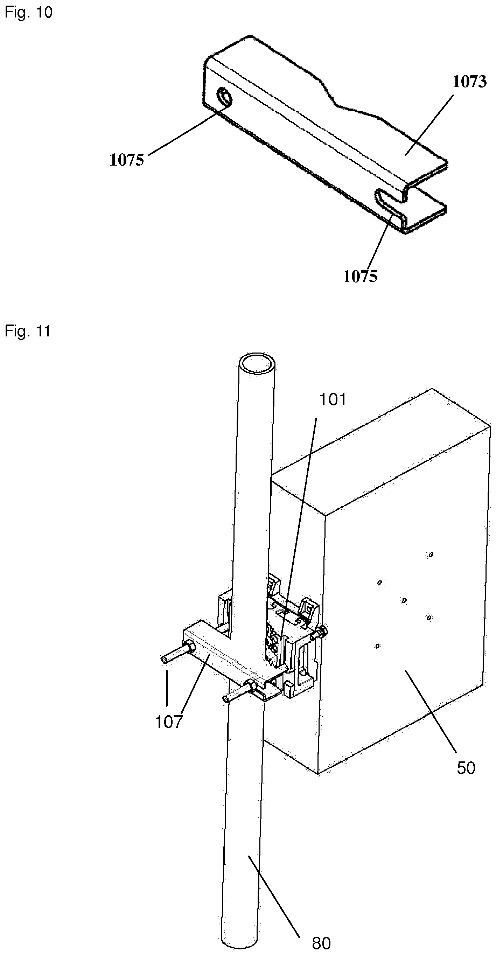

As shown in Fig. 9, the connection piece 107 includes a first connection component 1071 and a second connection component 1073; the second connection component 1073 is provided with a second installation hole 1075 (as shown in Fig. 10), the first connection component 1071 passes through the second installation hole 1075to install the fixing clamp 101 on the installation rod; the state after installation is as shown in Fig. 11. It is needed to note that the second installation hole 1075 can be of any shape, and when there are more than two second installation holes, all the second installation holes may be of the same shape, or part of the second installation holes may be of the same shape. In this embodiment, the first connection component may be a combination of a bolt and a nut; the shape of the second connection component 1073 is as shown in Fig. 10, and the second connection component 1073 may be a U-shaped component, or may be a fixing clamp installed opposite this fixing clamp, at this time the implementation mode is similar to the first implementation mode, that is, two installation holes are provided on the two fixing clamps respectively, and the first connection piece passes through the two installation holes to realize the installation of the fixing clamp; the detail can refer to the first implementation mode and no further description is needed here.

In order to enhance the fastness of the installed fixing clamp 101 and the installed installation rod, as shown in Fig. 2, a V-shaped groove 1013 is provided on the fixing clamp 101; all V-shaped grooves 1013 are matched with each other to form an accommodation space; and the body of the installation rod passes through the accommodation space. The V-shaped groove 1013 may be arranged at the middle part of the fixing clamp 101.

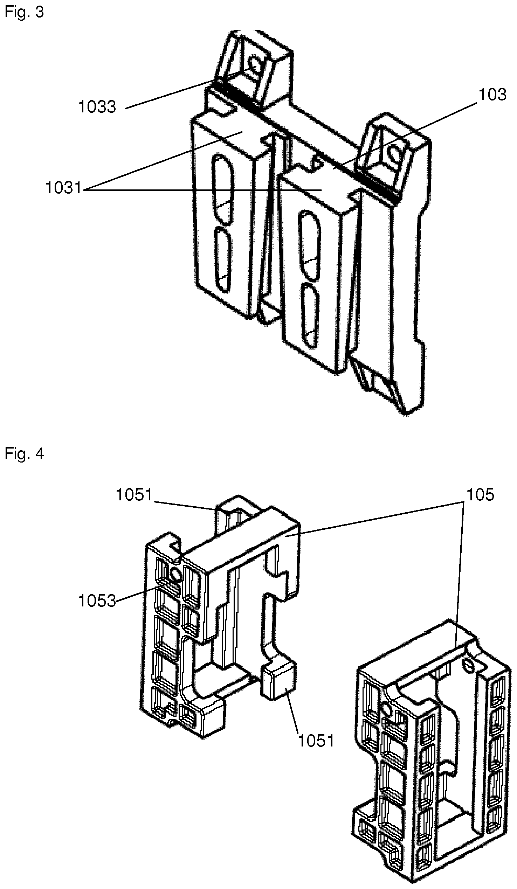

In this embodiment, there are multiple installation modes for the fixing clamp 101 and the installation plate 103, for example, a fixing mode by means of a bolt can be adopted; in a preferred implementation of the embodiment, a hanging mode also may be adopted for installation, specifically, as shown in Fig. 2 and Fig. 3, a hanging groove 1015 is provided on the fixing clamp; a lug 1031 is provided on the installation plate 103; the hanging groove 1015 is matched with the lug 1031 to install the installation plate 103 on the fixing clamp 101.

In this embodiment, there may be multiple installation modes for the fixing clamp 101 and the adapter plate 105, for example, a fixing mode by means of a bolt may be adopted or a hanging mode may be adopted; for the hanging mode, the specific implementation mode is as follows: as shown in Fig. 2 and Fig. 4, a first hanging structure 1017 is provided on the fixing clamp 101; a second hanging structure 1051 is provided on the adapter plate 105; the first hanging structure 1017 is matched with the second hanging structure 1051 to install the adapter plate 105 on the fixing clamp 101. In specific application, the hanging structure 1017 can be arranged on two sides of the fixing clamp 101, and the second hanging structure may be a hanging groove.

Since the hanging mode is easy to make the installation become loose, a first locking structure 1019 and a second locking structure 1053 that are mutually matched are provided on the first hanging structure 1017 and the second hanging structure 1051 respectively; the fixing clamp 101 and the adapter plate 105 are locked through the first locking structure 1019 and the second locking structure 1053 that are mutually matched. In specific application, the first locking structure 1019 might be a locking groove 1015, the second locking structure might be a locking interface, the first locking structure 1019 and the second locking structure 1053 are connected in a locking manner through a locking piece 1021 (as shown in Fig. 7). Two sides of the adapter plate 105 may be respectively provided with a fixing clamp 101, so that two fixing clamps 101 can be fixed together, this fixing mode also can be adopted to fix multiple fixing clamps 101.

As shown in Fig. 2 and Fig. 4, there are multiple types of the first locking structure 1019 and the second locking structure 1053, for example, the first locking structure 1019 may be a locking groove and the second locking structure may be a thread hole; the locking groove and the thread hole lock the fixing clamp 101 and the adapter plate 105 via a screw (that is, the locking piece 1021, as shown in Fig. 7). The locking groove may be a conical groove.

In order to realize the installation of multiple apparatuses, there might be multiple adapter plates 105, so as to further extend the installation of multiple fixing clamps 101 and the installation of the installation plate 103, thereby realizing the installation of multiple apparatuses.

In this embodiment, the connection piece 107 might include but are not limited to a combination of a bolt and a nut.

The specific implementation of the installation device provided in Embodiment 1 in realizing the installation of an apparatus is described below in detail in conjunction with Embodiment 2.

### Embodiment 2

The installation device in this embodiment is the same as that in Embodiment 1, which includes a fixing clamp 101, an installation plate 103, an adapter plate 105, a pole connection piece 107, and a coupled locking piece 1021, wherein a V-shaped groove 1013 is provided at the middle part of the fixing clamp 101, for holding an installation rod. The state of holding the installation rod is as shown in Fig. 6; two fixing clamps 101 are arranged opposite each other, and are connected and fixed through two connection pieces 107, as shown in Fig. 6.

The installation plate 103 and an apparatus 50 are fixed closely via an installation hole 1033 (as shown in Fig. 3) on the installation plate (as shown in Fig. 5), and are mounted in a hanging groove 1015 on the fixing clamp 101 on the pole via a lug 1031 (as shown in Fig. 3) on the installation plate 103.

In addition, two fixing clamps 101 on the pole also can hang an apparatus. As shown in Fig. 8, when more than two apparatuses 50 are installed on a pole 80, an adapter plate 105 and another fixing clamp 101 can be mounted on a side of the fixing clamp 101; the number of the fixing clamp can be increased as needed; each additional fixing clamp 101 can hang an apparatus too, as shown in Fig. 7 and Fig. 8.

From the above embodiments, it can be seen that the disclosure achieves following effects:
the installation device can greatly reduce the procedure, complexity and working time of high-altitude operation and reduce the space occupied by installation, thereby reducing the cost of construction and enhancing the security of pole installation.

### Industrial Applicability

In the disclosure, pole installation is realized through a fixing clamp and a connection piece, an apparatus is installed through an installation plate and an adapter plate is used to extend the installation of fixing clamps to install more apparatuses, thus, the disclosure solves the technical problems in the related art that the existing installation mode has a narrow range of application and the operation is complex during installation, etc., thereby achieving the effects of a wide range of application and simple installation.

## Claims

1. An installation device, comprising a fixing clamp (101), an installation plate (103), an adapter plate (105) and a connection piece (107), wherein
the fixing clamp (101) is arranged on an installation rod via the connection piece (107) that is used in concert with the fixing clamp (101);
the installation plate (103) installs an apparatus via the fixing clamp (101) connected with the installation plate (103); and
the adapter plate (105) installs other fixing clamps except the fixing clamp (101) via the fixing clamp (101) connected with the adapter plate (105),
wherein the number of the fixing clamp (101) is at least two, the at least two fixing clamps (101) are installed in pairs on opposite sides of the installation rod;
wherein the at least two fixing clamps (101) are provided with V-shaped grooves (1013), all the V-shaped grooves (1013) are matched with each other to form an accommodation space, and a body of the installation rod passe, in use, through the accommodation space;
**characterized in that**, the fixing clamp (101) is provided with a first hanging structure (1017), the adapter plate (105) is provided with a second hanging structure (1051), the first hanging structure (1017) is matched with the second hanging structure (1051) to install the adapter plate (105) on the fixing clamp (101).

2. The device according to claim 1, wherein the fixing clamp (101) is provided with a first installation hole (1011), the connection piece (107) passes through two first installation holes (1011) on two fixing clamps arranged opposite each other to install the two fixing clamps (101) on the installation rod.

3. The device according to claim 1, wherein the connection piece (107) comprises a first connection component (1071) and a second connection component (1073); the second connection component (1073) is provided with a second installation hole (1075), the first connection component (1073) passes through the second installation hole (1075) to install the fixing clamp (101) on the installation rod.

4. The device according to claim 1, wherein the fixing clamp (101) is provided with a hanging groove (1015), the installation plate (103) is provided with a lug (1031), the hanging groove (1015) is matched with the lug (1031) to install the installation plate (103) on the fixing clamp (101).

5. The device according to claim 4, wherein the first hanging structure (1017) and the second hanging structure (1051) are respectively provided with a first locking structure (1019) and a second locking structure (1053) that are matched with each other, and lock the fixing clamp (101) and the adapter plate (105) through the first locking structure (1019) and the second locking structure (1053).

6. The device according to claim 5, wherein the first locking structure (1019) is a locking groove and the second locking structure is a thread hole, the locking groove and the thread hole lock the fixing clamp (101) and the adapter plate (105) via a screw.

7. The device according to any one of claims 1 to 4, wherein there are multiple adapter plates and a plurality of other fixing clamps.

## Patentansprüche

1. Installationsvorrichtung, umfassend eine Befestigungsklemme (101), eine Installationsplatte (103), eine Adapterplatte (105) und ein Verbindungsstück (107), wobei
die Befestigungsklemme (101) über das Verbindungsstück (107), das zusammen mit der Befestigungsklemme (101) verwendet wird, an einem Installationsmast angeordnet ist,
die Installationsplatte (103) über die Befestigungsklemme (101), die mit der Installationsplatte (103) verbunden ist, einen Apparat installiert, und
die Adapterplatte (105) andere Befestigungsklemmen außer der Befestigungsklemme (101) über die Befestigungsklemme (101), die mit der Adapterplatte (105) verbunden ist, installiert,
wobei die Anzahl der Befestigungsklemme (101) mindestens zwei beträgt, wobei die mindestens zwei Befestigungsklemmen (101) in Paaren auf gegenüberliegenden Seiten des Installationsmastes installiert sind,
wobei die mindestens zwei Befestigungsklemmen (101) mit V-förmigen Kerben (1013) versehen sind, wobei alle V-förmigen Kerben (1013) aufeinander abgestimmt sind, um einen Unterbringungsraum zu bilden, und ein Körper des Installationsmastes im Gebrauch durch den Unterbringungsraum verläuft,
**dadurch gekennzeichnet, dass**
die Befestigungsklemme (101) mit einer ersten Hängestruktur (1017) versehen ist, die Adapterplatte (105) mit einer zweiten Hängestruktur (1051) versehen ist, die erste Hängestruktur (1017) mit der zweiten Hängestruktur (1051) abgestimmt ist, um die Adapterplatte (105) an der Befestigungsklemme (101) zu installieren.

2. Vorrichtung nach Anspruch 1, wobei die Befestigungsklemme (101) mit einer ersten Installationsöffnung (1011) versehen ist, das Verbindungsstück (107) durch zwei erste Installationsöffnungen (1011) an zwei Befestigungsklemmen verläuft, die einander gegenüber angeordnet sind, um die zwei Befestigungsklemmen (101) an dem Installationsmast zu installieren.

3. Vorrichtung nach Anspruch 1, wobei das Verbindungsstück (107) ein erstes Verbindungsbauteil (1071) und ein zweites Verbindungsbauteil (1073) umfasst, das zweite Verbindungsbauteil (1073) mit einer zweiten Installationsöffnung (1075) versehen ist, das erste Verbindungsbauteil (1073) durch die zweite Installationsöffnung (1075) verläuft, um die Befestigungsklemme (101) an dem Installationsmast zu installieren.

4. Vorrichtung nach Anspruch 1, wobei die Befestigungsklemme (101) mit einer Hängekerbe (1015) versehen ist, die Installationsplatte (103) mit einer Nase (1031) versehen ist, die Hängekerbe (1015) mit der Nase (1031) abgestimmt ist, um die Installationsplatte (103) an der Befestigungsklemme (101) zu installieren.

5. Vorrichtung nach Anspruch 4, wobei die erste Hängestruktur (1017) und die zweite Hängestruktur (1051) jeweils mit einer ersten Arretierungsstruktur (1019) und einer zweiten Arretierungsstruktur (1053) versehen sind, die aufeinander abgestimmt sind, und die Befestigungsklemme (101) und die Adapterplatte (105) durch die erste Arretierungsstruktur (1019) und die zweite Arretierungsstruktur (1053) arretieren.

6. Vorrichtung nach Anspruch 5, wobei die erste Arretierungsstruktur (1019) eine Arretierungskerbe ist und die zweite Arretierungsstruktur eine Gewindeöffnung ist, wobei die Arretierungskerbe und die Gewindeöffnung die Befestigungsklemme (101) und die Adapterplatte (105) über eine Schraube arretieren.

7. Vorrichtung nach einem der Ansprüche 1 bis 4, wobei mehrere Adapterplatten und mehrere andere Befestigungsklemmen vorhanden sind.

## Revendications

1. Dispositif d'installation comprenant une pince de fixation (101), une plaque d'installation (103), une plaque d'adaptateur (105) et une pièce de raccordement (107), dans lequel :
la pince de fixation (101) est agencée sur une tige d'installation via la pièce de raccordement (107) qui est utilisée de concert avec la pince de fixation (101) ;
la plaque d'installation (103) installe un appareil via la pince de fixation (101) raccordée avec la plaque d'installation (103) ; et
la plaque d'adaptateur (105) installe les autres pinces de fixation, excepté la pince de fixation (101) via la pince de fixation (101) raccordée avec la plaque d'adaptateur (105),
dans lequel le nombre de pinces de fixation (101) est au moins de deux, les au moins deux pinces de fixation (101) sont installées en paires sur les côtés opposés de la tige d'installation ;
dans lequel les au moins deux pinces de fixation (101) sont prévues avec des rainures en forme de V (1013), toutes les rainures en forme de V (1013) correspondent les unes aux autres afin de former un espace de logement, et un corps de la tige d'installation passe, lors de l'usage, à travers l'espace de logement ;
**caractérisé en ce que** :
la pince de fixation (101) est prévue avec une première structure de suspension (1017), la plaque d'adaptateur (105) est prévue avec une seconde structure de suspension (1051), la première structure de suspension (1017) correspond à la seconde structure de suspension (1051) pour installer la plaque d'adaptateur (105) sur la pince de fixation (101).

2. Dispositif selon la revendication 1, dans lequel la pince de fixation (101) est prévue avec un premier trou d'installation (1011), la pièce de raccordement (107) passe à travers deux premiers trous d'installation (1011) sur deux pinces de fixation agencées de manière opposée entre elles pour installer les deux pinces de fixation (101) sur la tige d'installation.

3. Dispositif selon la revendication 1, dans lequel la pince de raccordement (107) comprend un premier composant de raccordement (1071) et un second composant de raccordement (1073) ; le second composant de raccordement (1073) est prévu avec un second trou d'installation (1075), le premier composant de raccordement (1073) passe à travers le second trou d'installation (1075) afin d'installer la pince de fixation (101) sur la tige d'installation.

4. Dispositif selon la revendication 1, dans lequel la pince de fixation (101) est prévue avec une rainure de suspension (1015), la plaque d'installation (103) est prévue avec une patte (1031), la rainure de suspension (1015) correspond à la patte (1031) pour installer la plaque d'installation (103) sur la pince de fixation (101).

5. Dispositif selon la revendication 4, dans lequel la première structure de suspension (1017) et la seconde structure de suspension (1051) sont respectivement prévues avec une première structure de verrouillage (1019) et une seconde structure de verrouillage (1053) qui correspondent l'une à l'autre et verrouillent la pince de fixation (101) et la plaque d'adaptateur (105) à travers la première structure de verrouillage (1019) et la seconde structure de verrouillage (1053).

6. Dispositif selon la revendication 5, dans lequel la première structure de verrouillage (1019) est une rainure de verrouillage et la seconde structure de verrouillage est un trou fileté, la rainure de verrouillage et le trou fileté verrouillent la pince de fixation (101) et la plaque d'adaptateur (105) via une vis.

7. Dispositif selon l'une quelconque des revendications 1 à 4, dans lequel il y a plusieurs plaques d'adaptateur et une pluralité d'autres pinces de fixation.
